Europäisches Patentamt

European Patent Office

Office européen des brevets

(11) Publication number: 0 329 317
A2

# EUROPEAN PATENT APPLICATION

(21) Application number: 89301124.7

(22) Date of filing: 06.02.89

(51) Int. Cl.4: H01L 23/14 , H01L 21/58 , H01L 23/50

The title of the invention has been amended (Guidelines for Examination in the EPO, A-III, 7.3).

(30) Priority: 12.02.88 JP 30111/88

(43) Date of publication of application:
23.08.89 Bulletin 89/34

(84) Designated Contracting States:
DE FR GB IT

(71) Applicant: HITACHI, LTD.
6, Kanda Surugadai 4-chome
Chiyoda-ku Tokyo 101(JP)

(72) Inventor: Yasuhara, Toshihiro
3, Hitachi-namikiso 1-21-1, Namiki-cho
Kokubunji-shi Tokyo(JP)
Inventor: Masuda, Masachika
489-1-202, Naka-machi
Kodaira-shi Tokyo(JP)
Inventor: Murakami, Gen
3048, Onoji-machi
Machida-shi Tokyo(JP)

(74) Representative: Calderbank, Thomas Roger et al
MEWBURN ELLIS & CO. 2/3 Cursitor Street
London EC4A 1BQ(GB)

(54) Semiconductor device having an insulating sheet.

(57) A semiconductor device has an insulating filmy resin sheet (2) stuck on the principal surface of a semiconductor chip (4) formed with circuits. The inner lead portions (15) of a lead frame (14) are arranged on the insulating sheet (2), so that the semiconductor chip having the highest possible density of integration may be received in a standardized package. The inner lead portions (15) lie within a sealing member (6) and are substantially entirely arrayed over the semiconductor chip (4). The fore ends of the inner lead portions (15) and the external terminals of the semiconductor chip (4) are electrically connected on the shorter latus side of the semiconductor chip (4) by pieces of bonding wire (5).

FIG. 2

# SEMICONDUCTOR DEVICE AND METHOD OF MANUFACTURING THE SAME

The present invention relates to a semiconductor device in which the semiconductor chip is encapsulated by e.g. resin.

In a resin-encapsulated semiconductor device, as the size of the semiconductor chip becomes larger, the spacing between the side of the package and the tab thereof (the tab being a part for mounting the semiconductor chip) tends to be increasingly narrow. This is because, although the size of the semiconductor chip (pellet) is increased, the size of the package for receiving the semiconductor chip is standardised and cannot be increased.

A conventional semiconductor integrated circuit device of the memory type, a dual in-line type resin-sealing package normally has a bent width of 300 mils (7.62 mm).

Thus, a device such as a memory type semiconductor integrated circuit device has had the size of its semiconductor chip enlarged in the lengthwise direction with increasing integration density. In addition, a memory type semiconductor integrated circuit device has bonding pads of the semiconductor chip chiefly arranged along both the shorter latera of the semiconductor chip, which is normally rectangular.

Hence, there is the problem that, as the density of integration rises more in a memory type semiconductor integrated circuit device, it becomes very difficult to keep the bent width to the standard 300 mils for a dual in-line type resin-sealing package. When the size of the semiconductor chip is increased and enlongated the bonding pads are chiefly arranged along the shorter latera, and the chip is located in a dual in-line type resin-sealing package whose lateral width is limited, the wiring space within the package becomes insufficient for the inner leads.

It is therefore desirable to provide a semiconductor device comprising a resin-sealing package which can maintain sufficient wiring space for the inner leads even when encapsulating a large and elongate semiconductor chip with bonding pads arranged chiefly along the shorter latera.

A semiconductor device to be discussed below has been proposed to seek to meet this criteria.

Such a semiconductor device comprises a semiconductor chip, a plurality of leads which form external terminals which are electrically independent of one another, pieces of bonding wire which bridge the respective leads and the semiconductor chip, and a package which seals the semiconductor chip, the leads and the bonding wire pieces with a resin. In such a device inner parts (hereinafter, also referred to as "inner leads") of, at least some of the leads lie under the semiconductor chip within the package, and an insulator layer is interposed between the inner leads and the semiconductor chip.

In such a semiconductor device, the inner leads of, at least some of the leads lie partly under the semiconductor chip within the resin-sealing package, so that sufficient wiring space for the inner leads can be maintained. Accordingly, the inner leads can be satisfactory wired in the package even when, by way of example, a large and elongate semiconductor chip which has bonding pads arranged chiefly along the shorter latera thereof is to be received in the dual in-line type resin-sealing package whose lateral width is limited.

Moreover, since an insulator layer is interposed between the semiconductor chip and the inner leads laid thereunder, the insulation between the semiconductor chip and the leads is satisfactory, and the semiconductor chip can be firmly fixed within the resin-sealing package.

Such semiconductor devices are described in, for example, the official gazettes of Japanese Patent Application Laid-Open No. 114261/1982, No. 218139/1986 and No. 258458/1986.

However, it has been found that, in a semiconductor device such as those discussed above in which the semiconductor chip is placed on the inner leads of some of the leads, the operation of wire bonding to the free ends of the inner leads (which protrude beyond the shorter latus sides of the semiconductor chip) requires lead "keeping allowances" as an addition to the free end parts of the inner leads in order to avoid dispersion of the leads and to prevent ultrasonic waves from missing in the wire bonding operation. That is, when there are no "keeping allowances", the wire pieces are poorly bonded at the free ends of the inner leads, causing short-circuiting.

Further, unless the free ends of the inner leads extend sufficiently from under the shorter latera of the semiconductor chip, the wire pieces sag and short-circuit into contact with the semiconductor chip, when the bonding pads (external terminals) and the leads are connected.

These problems have made it impossible to increase the size of the semiconductor chip sufficiently.

Furthermore, if it is desired to apply the semiconductor chip to different packages in common, there is the problem that the wire pieces cross, causing short-circuits, due to the different pad arrangements of the packages. This has necessitated semiconductor chips being prepared separately for different package arrangements.

Also, chip coating has been required to prevent soft errors ascribable to alpha particles.

The present invention seeks to overcome, or at least ameliorate, at least some of these problems. At its most general, the present invention proposes that the free ends of the leads extend over the principal surface of the chip (the surface carrying the external terminals) with an insulator layer therebetween. In this way, several advantages may be achieved.

It becomes possible to provide a semiconductor device of higher packaging density without altering the size of the package. Hence the chip occupation rate of the package may be increased.

By suitable selection of the insulator layer, it may be possible to provide a semiconductor device which efficiently prevents soft errors ascribable to alpha particles. Hence a semiconductor device of high packaging density and high reliability may be provided in which a chip of· large capacity is mounted in a conventional package or in which a semiconductor chip can be applied to different packages in common.

Thus, in a resin-encapsulated semiconductor device, an insulator film (which may be capable of checking alpha particles) may be provided on the principal surface of a semiconductor chip in which bonding pads (external terminals) are chiefly arranged along the shorter latus sides thereof. The free ends of the inner leads of the leads of a tabless lead frame which extend round to positions near the bonding pads are arranged on the insulator film, and the inner leads and the bonding pads are electrically connected by pieces of bonding wire. Preferably, the leads have all the inner lead parts arranged on the semiconductor chip, and the operation of wire bonding is entirely performed on the chip.

Through holes may be provided in suitable positions in the insulator film, and the corresponding parts may then be used as pads for electrodes and may be electrically connected by pieces of bonding wire with the free ends of the inner lead parts extended round on the semiconductor chip.

The loop heights of the bonding wire pieces may be adjusted on some of the bonding pads, so that the bonding wire pieces may cross.

Thus, a semiconductor device according to the present invention may have:
an oblong semiconductor chip whose principal surface is formed with circuits having various functions, and in which external terminals (bonding pads) for deriving signals of said circuits are arranged on both shorter latus sides thereof;
a rectangular sheet which is made of an insulating filmy resin and which is mounted on the principal surface of said semiconductor chip through an adhesive;
leads each of which is made up of an inner lead portion and an outer lead portion, and which are brought from longer latus sides of said oblong semiconductor chip onto said sheet and are extended round from longer latera of said semiconductor chip toward shorter latera thereof so that fore ends of said inner lead portions may be arranged at positions near shorter latera of said rectangular sheet;
pieces of metallic fine wire which electrically connect said external terminals and the fore ends of said inner lead portions; and
a sealing member which encapsulates therein said semiconductor chip, the insulating filmy resin sheet, said inner lead portions, the metallic fine wire pieces and said external terminals.

The inner leads of the tabless lead frame may then be arranged on the principal surface of the semiconductor chip. The leads can then be utilized as a wiring layer, so that the wire bonding to the inner leads can be carried out from suitable positions on the semiconductor chip. By way of example, when the insulator film is used as the interlayer insulator sheet and is provided with the through holes (contacts) as stated before by treating the leads as the wiring layer, wiring leads can be laid from any location.

In addition, since the wire bonding is on the principal surface of the semiconductor chip, attention need be paid only to short-circuiting between the bonding wire pieces. The insulator film and the inner leads pose no problem even when contacts exist on the principal surface of the semiconductor chip. Therefore, the short-circuiting (area shorting) between the end part of the semiconductor chip and the wire piece can substantially be eliminated. Accordingly, cross wire bonding is also permitted by adjusting only the loop heights of the wire pieces, and different packages such as a small outline J-bend (hereinbelow, termed "SOJ") and a zigzag in-line package ("ZIP") to which different semiconductor chips have been applied can also be manufactured using a common semiconductor chip and by performing cross wire bonding.

The bonding wire pieces may be made low and short and can also be readily bonded in parallel with the direction of flow of a sealing resin in the encapsulating operation thereof, so that deformations of the bonding wire pieces can be reduced.

Furthermore, all the inner leads may be arranged so that they lie on the upper surface of the semiconductor chip. Then, neither the free ends of the inner leads nor any other lead parts surround the periphery of the semiconductor chip, so the size of the chip may then be enlarged satisfactorily.

An embodiment of the invention will now be described in detail, by way of example, with reference to the accompanying drawings, in which:

Fig. 1 is a plan view illustrating the structure of the interior of a package of a resin-encapsulated semiconductor device of a first embodiment, in which the present invention is applied to a 4-megabit dynamic random access memory (4MDRAM) with the SOJ type package;

Fig. 2 is a sectional view of the 4MDRAM shown in Fig. 1 as taken along line II - II;

Fig. 3 is a sectional view of the 4MDRAM shown in Fig. 1 as taken along line III - III;

Fig. 4 is a plan view for explaining the layout of a semiconductor chip shown in Fig. 1;

Fig. 5 is a plan view showing the arrangement of pads on the semiconductor chip shown in Fig. 1;

Fig. 6 is an expanded view of a cross wire bonding part shown in Fig. 1; and

Fig. 7 is a view for explaining adhesives employed for arranging inner leads on the principal surface of the semiconductor chip shown in Fig. 1.

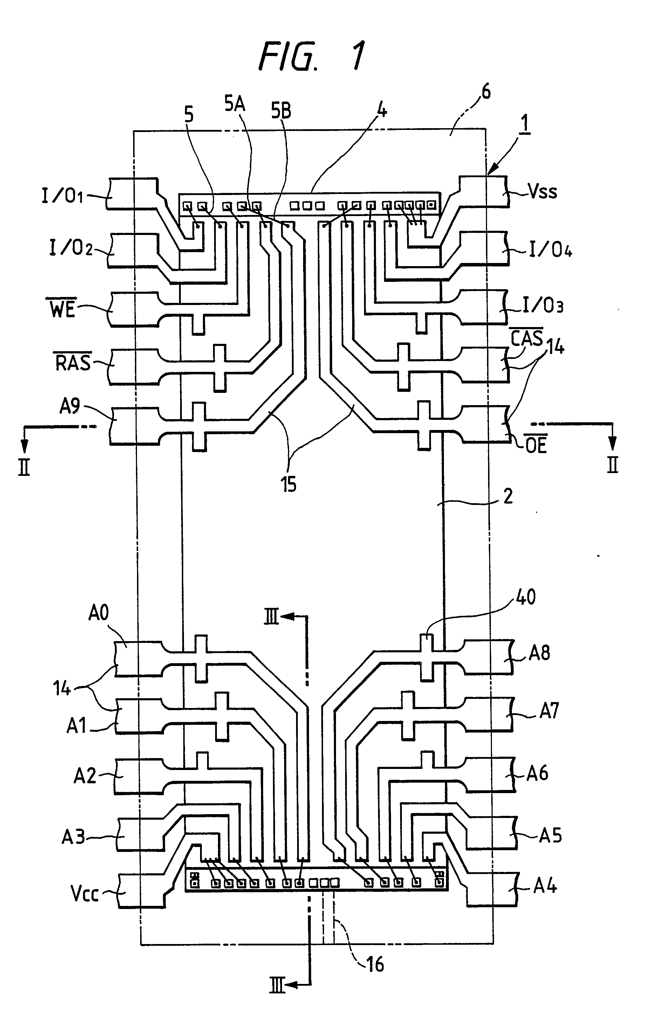

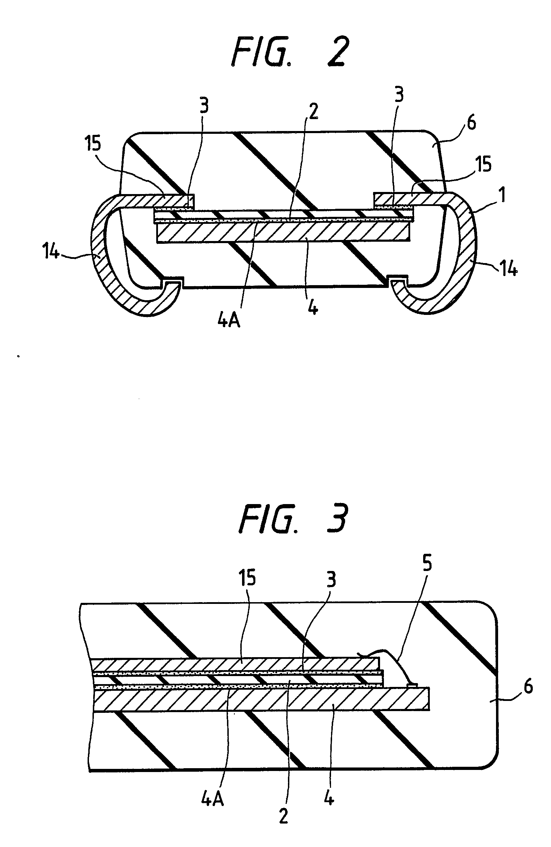

As illustrated in Figs. 1 -3, a resin-encapsulated semiconductor device according to this embodiment is based on a semiconductor chip of a 4MDRAM memory. An insulator film 2 is bonded using an adhesive 3 onto the inner lead parts 15 of a tabless lead frame 1 in a reversed state. The semiconductor chip 4 of the 4MDRAM is pellet-fixed onto the insulator film 2 by a pellet fixing thermosetting adhesive 4A with its principal surface set as a bonding surface, and that the resultant structure is reversed. Then, the inner lead parts 15 and the semiconductor chip 4 are electrically connected by pieces of bonding wire 5. Thus, the inner lead portions 15 of the tabless lead frame 1 are arranged on the principal surface of the semiconductor chip 4 of the 4MDRAM via the insulator film 2. The structure is next encapsulated with a resin sealant 6, the outer lead parts 14 of the tabless lead frame 1 are worked into a predetermined shape. As the size of the package of the device, the dimension of each shorter latus is 7.62 mm (300 mils), and that of each longer latus is 16.9 mm (675 mils).

As shown in Fig. 1, the tabless lead frame 1 is formed of a thin flat plate (having a thickness of, for example, 0.25 mm) which is made of an iron-based (iron or its alloy) material such as 42 Alloy or Kovar or a copper-based (copper or its alloy) material such as phosphor bronze or tough-pitch copper.

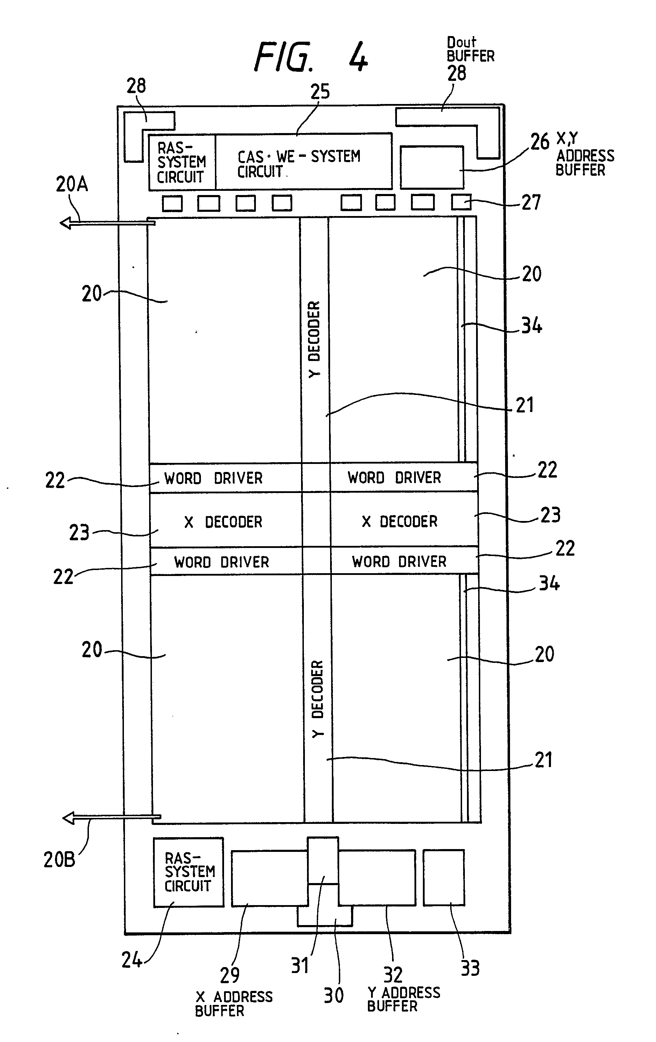

The semiconductor chip 4 forms the 4MDRAM. As shown in Fig. 4, memory mats 20 are provided at the central part of this semiconductor chip, Y decoders 21 are provided at the X-directional central part thereof and in parallel with a Y-axis so as to extend along the memory mats 20, and word drivers 22 and X decoders 23 are provided at the Y-dirctional central part thereof and in parallel with an X-axis so as to extend along the memory mats 20.

In addition, at one end part of the semiconductor chip in the lengthwise direction thereof, a RAS-group circuit 24, a CAS-group/WE-group circuit 25 and an X/Y address buffer 26 are respectively provided, main amplifiers 27 are provided inside them, and $D_{out}$ buffers 28 are provided at the corners of the end part. At the other end part, there are provided a RAS-group circuit 24, an X address buffer 29, an X generator 30, an X/Y generator 31, a Y address buffer 32 and an SHR/PC generator 33. Besides, sense amplifiers/common inputs and outputs/common sources 34 are provided at the right side end part of the semiconductor chip in the widthwise direction thereof, and the upper terminals 20A of the memory mats 20 are provided at the upper end of the left side end part thereof, while the lower terminals 20B of the memory mats 20 are provided at the lower end.

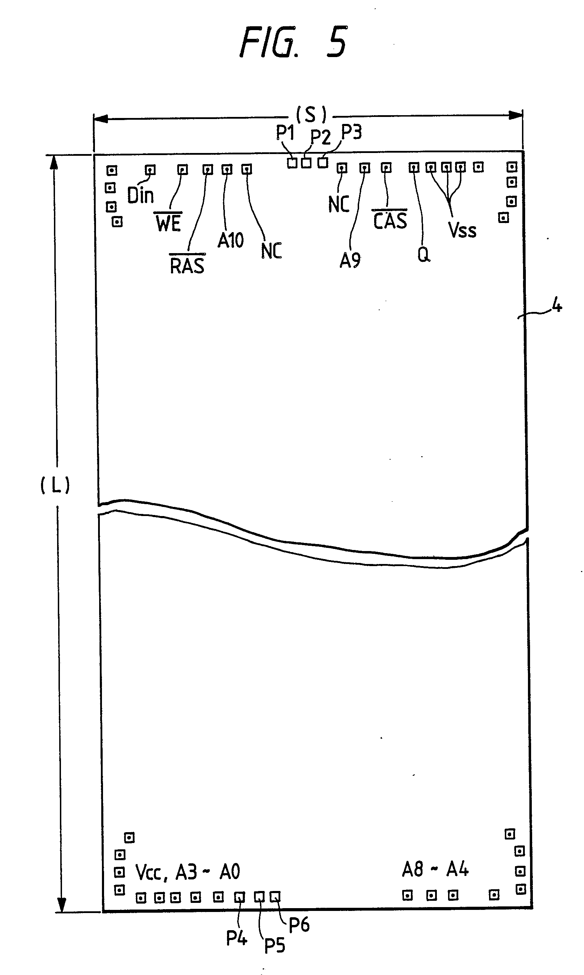

As shown in Fig. 5, the electrodes (pads) A0 - A10, electrodes (pads) $D_{in}$, $\overline{WE}$, $\overline{RAS}$, NC, $V_{ss}$, $V_{cc}$, Q ($D_{out}$) and $\overline{CAS}$ and electrodes (pads) P1 - P6 of various elements provided in the semiconductor chip 4 are arranged at both the end parts of the semiconductor chip 4 in the lengthwise direction thereof. The pads A0 - A10 are for bonding signal lines, the pad $D_{in}$ is for a data input signal, the pad $\overline{WE}$ is for the $\overline{WE}$ circuit of the $\overline{CAS}$ group/ $\overline{WE}$ group circuit 25, the pad $\overline{RAS}$ is for the $\overline{RAS}$ group circuit 24, the pad $V_{ss}$ is for a power source voltage $V_{ss}$, pads I/O1 - I/O4 (refer to Fig. 1) are for the $D_{out}$ buffer 28, and the pad $\overline{CAS}$ is for the $\overline{CAS}$ group circuit of the $\overline{CAS}$ group/ $\overline{WE}$ group circuit 25. Further, the pads P1 - P6 are probing pads which are used in the tests of electrical characteristics.

As the size of the semiconductor chip 4, the dimension (S) of each shorter latus is 5.91 mm, and the dimension (L) of each longer latus is 15.22 mm.

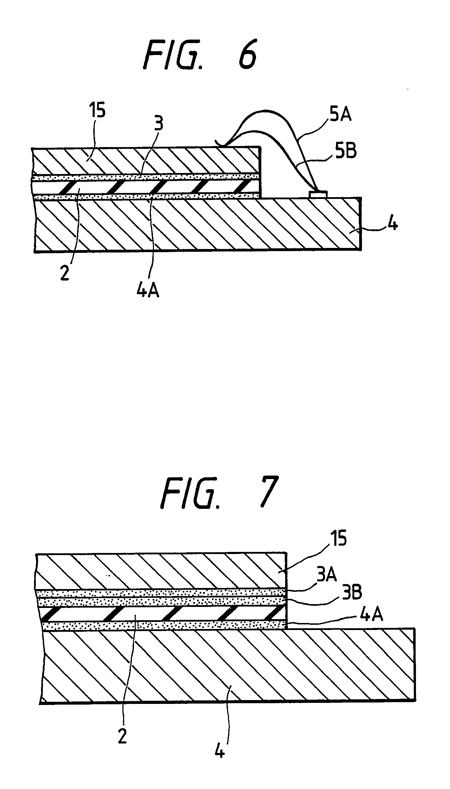

The corresponding inner leads are electrically connected to the respective pads by the bonding wire pieces 5. In this regard, as shown in Fig. 1 by way of example, a bonding wire piece 5A for electrically connecting the pad $\overline{RAS}$ and the inner lead $\overline{RAS}$ is laid so as to extend across a bonding wire piece 5B for electrically connecting the pad A9 and the inner lead A9. Here, as shown in Fig. 6, the bonding wire piece 5B has the loop height thereof made lower than that of the bonding wire piece 5A so as not to short-circuit. To change the loop heights in this manner is utilized in case of using one sort of semiconductor chip for different packages in common. For example, in a case where a chip having heretofore been applied to a DIP (dual in-line package) is to be mounted on an SOJ (small out-line J-bend package), the pad arrangements of the packages are partly different, and hence, the wire loop heights need to be changed for the cross wire bonding in order to connect some pads and the inner lead portions 15.

Now, a process for assembling the resin-encapsulated semiconductor device of this embodiment will be described.

As seen from Figs. 1 thru 3, first of all, the insulator film 2 made of a polyimide type resin is bonded with the adhesive 3 onto the inner lead portions 15 of the tabless lead frame 1 in the reversed state. A polyimide type resin film having a thickness of 125 $\mu$m is used as the insulator film 2. Used as the adhesive 3 is, for example, a multilayer adhesive in which, as shown in Fig. 7, a thermoplastic binder 3A of polyether amide imide or the like and a thermosetting polyimide type resin binder 3B of polyimide pyromellite, polyketone imide or the like are stacked in this order from the side of the inner lead portions 15. The principal surface side of the semiconductor chip 4 is pellet-fixed onto the insulator film 2 by the pellet fixing thermosetting adhesive 4A. Used as the pellet fixing thermosetting adhesive 4A is, for example, a multilayer adhesive in which a nonconductive paste material, e. g., silicone rubber, epoxy rubber, epoxy type resin or polyimide type resin is stacked on a thermosetting polyimide type resin binder of polyimide pyromellite, polyketone imide or the like.

Subsequently, the bonding terminal portion 15A of each inner lead portion 15 and the corresponding pad on the principal surface of the semiconductor chip 4 subjected to the pellet fixing operation are electrically connected by the piece of bonding wire 5. By way of example, gold (Au) wire having a diameter of 30 $\mu$m is used as the bonding wire 5. Regarding the wire bonding, by way of example, the bonding wire piece 5 and each of the pads A0 - A10 on the semiconductor chip 4 are connected by wedge ball bonding. Likewise, the bonding wire piece 5 and the bonding terminal portion 15A of the inner lead portion 15 are connected by thermocompression employing ultrasonic vibrations jointly. That part of the bonding terminal portion 15A of the inner lead portion 15 which is to be bonded is plated with silver (Ag). In electrically connecting the semiconductor chip 4 and the inner lead portions 15 by the use of the bonding wire pieces 5, the bonding positions (2 points) of the pads on the side of the semiconductor chip 4 are recognized to determine coordinates, whereupon the wire bonding is automatically carried out.

When the wire bonding has ended, the injection port of the cavity of a resin sealant injection apparatus and the gate position 16 of the tabless lead frame 1 are positioned, and thereafter, the resin sealant 6 such as epoxy type resin is poured into the cavity and then molded. The outer lead portions 14 are thereafter worked into the predetermined shape. Thus, the resin-encapsulated semiconductor device is finished up.

Now, the lead frame 1 will be described.

The lead frames 1 are juxtaposed in a unidirectional array to form a multiple lead frame though not shown. The multiple lead frame is unitarily formed in such a way that the single sheet of the lead frame material mentioned before is subjected to a proper expedient such as punching press work or etching process. As shown in Fig. 1, each of the lead frames 1 is so shaped that the leads thereof enter from the longer latus sides of the oblong package and extend to the shorter latus sides. In particular, the leads (pins $V_{ss}$, A4, $V_{cc}$ and I/O1) entering from the four corners of the package enter from substantially the same positions as those of the shorter latera of the semiconductor chip 4, and the corresponding inner leads extend toward the center of the semiconductor chip 4 and further to positions near the bonding pads arranged on the shorter latus sides of the semiconductor chip 4.

In addition, since the leads arranged centrally of the chip 4 extend long within the package, they are liable to come off due to the poor adhesion thereof with the sealing resin. In order to prevent this drawback, the leads are formed with lugs 40 at those positions of the inner leads which are comparatively close to the side surfaces of the chip 4.

As understood from the above description, according to this embodiment, the inner lead portions 15 of the tabless lead frame 1 are arranged on the principal surface of the semiconductor chip 4 through the insulator film 2, whereby a space for arranging the inner lead portions 15 around the semiconductor chip 4 as in the prior art is dispensed with, and the semiconductor chip 4 which is larger to that extent can be mounted.

In addition, owing to the· arrangement of the inner lead portions 15 of the tabless lead frame 1 on the principal surface of the semiconductor chip 4, the inner lead portions 15 can be utilized as a wiring layer. That is, it is possible to execute the operation of wire bonding from the desired positions of the semiconductor chip 4 to the inner lead portions 15. This signifies that, when the inner lead portions 15 are considered as the wiring layer and the insulator film 2 as an inter-layer insulator film is provided with through holes (contacts), wiring can be laid from any places.

Besides, all the inner leads and the pads are subjected to the wire bonding on the principal surface of the semiconductor chip 4, whereby the short-circuiting (area shorting) between the end parts of the semiconductor chip 4 and the pieces of bonding wire 5 is basically avoided, and the wiring is facilitated. More specifically, since merely the insulator film 2 and the inner leads 15 which pose no problem even when contacted are existent on the semiconductor chip 4, attention may be paid only to the short-circuiting between the bonding wire pieces 5. Accordingly, the cross wire bonding is also permitted by adjusting only the loop heights of the bonding wire pieces 5. Thus, even a package of different sort such as an SOJ package, to which a different semiconductor chip 4 has been inevitably applied, can be manufactured using the common semiconductor chip 4 and by performing the cross wire bonding.

Besides, the bonding wire pieces 5 can be made low and short and can also be readily bonded in parallel with the flowing direction of the sealing resin material 6 in the encapsulating operation thereof, so that the deformations of the bonding wire pieces 5 can be relieved.

In addition, the arrangement of the pads of the semiconductor chip 4 can have its versatility sharply increased as compared with the same in the prior art.

Moreover, since the insulating film made of the polyimide resin is stuck on the principal surface of the semiconductor chip 4, soft errors ascribable to alpha particles can be prevented without the separate step of chip coating. That is, the number of steps is reduced.

## Claims

1. A semiconductor device comprising:
a rectangular semiconductor chip having external terminals on a principal surface thereof;
an insulator sheet which is bonded to the principal surface of the semiconductor chip;
a plurality of leads which extend on said insulator sheet so as to overlie the principal surface of the semiconductor chip each of the leads including an inner lead part and an outer lead part;
pieces of metallic fine wire which electrically connect the external terminals and free ends of the inner lead parts; and
a sealing member which encapsulates the semiconductor chip, the insulator sheet, the inner lead parts and the metallic fine wire pieces;
the external terminals being located on shorter latus sides of the semiconductor chip, and the free ends of the inner lead parts are located near the external terminals.

2. A semiconductor device according to claim 1, wherein the insulator sheet is of a polyimide type resin.

3. A semiconductor device according to claim 1 or claim 2, wherein the metallic fine wire is gold wire.

4. A semiconductor device according to any one of the preceding claims, having a first adhesive layer which bonds the semiconductor chip and the insulator sheet, and a second adhesive layer which bonds the insulator sheet and the inner lead portions.

5. A semiconductor device according to claim 4, wherein the first adhesive layer is of a multiple adhesive layer in which thermosetting polyimide type resins are stacked.

6. A semiconductor device according to claim 5, wherein the multiple adhesive layer is of polyimide pyromellite and polyketone imide.

7. A semiconductor device according to any one of claims 4 to 6, wherein the second adhesive layer is of a thermoplastic resin.

8. A semiconductor device according to claim 7, wherein the thermoplastic resin is polyether amide imide.

*FIG. 1*

# FIG. 2

# FIG. 3

## FIG. 4

Dout BUFFER 28

28

25

CAS · WE – SYSTEM CIRCUIT

RAS – SYSTEM CIRCUIT

26 X,Y ADDRESS BUFFER

20A

27

20

20

34

Y DECODER

21

22 WORD DRIVER    WORD DRIVER 22

23 X DECODER    X DECODER 23

22 WORD DRIVER    WORD DRIVER 22

34

20

20

Y DECODER

21

20B

RAS – SYSTEM CIRCUIT

24

29 X ADDRESS BUFFER

31    30    32 Y ADDRESS BUFFER    33

## FIG. 5

(S)

P1 P2 P3

Din

WE

RAS

A10

NC

NC

CAS

A9

Q

Vss

4

(L)

Vcc, A3 ~ A0

A8 ~ A4

P4 P5 P6

## FIG. 6

## FIG. 7